# EUROPEAN PATENT APPLICATION

(11) **EP 4 506 412 A1**
(43) Date of publication of application: **12.02.2025**
(21) Application number: 23774562.5
(22) Date of filing: 09.03.2023
(51) Int. Cl.: C08L 25/06, B32B 15/08, C08K 3/40, H05K 1/03

(54) **MOLDED STYRENE-BASED RESIN**

(30) Priority: 25.03.2022 JP 2022050817
(71) Applicant: Toyobo Co., Ltd., Kita-ku Osaka-shi, Osaka 530-0001 (JP)
(72) Inventor: SASAKI, Hironao, Osaka-shi, Osaka 530-0001 (JP); TOGAWA, Keiichiro, Otsu-shi, Shiga 520-0292 (JP); HIRASAWA, Fujio, Osaka-shi, Osaka 530-0001 (JP); HIRONAKA, Nobuyuki, Osaka-shi, Osaka 530-0001 (JP); KURITA, Tomoharu, Otsu-shi, Shiga 520-0292 (JP); IRIE, Michihiko, Otsu-shi, Shiga 520-0292 (JP); MAEDA, Yuki, Otsu-shi, Shiga 520-0292 (JP)
(74) Representative: Müller-Boré & Partner Patentanwälte PartG mbB
(86) International application number: PCT/JP2023/009034
(87) International publication number: WO 2023/181963

(57) **Abstract**

An object of the present invention is to provide a styrene-based resin molded body containing a syndiotactic polystyrene-based resin, the resin molded body having a low transmission loss, and having heat resistance.

A styrene-based resin molded body contains a syndiotactic polystyrene-based resin, a low-dielectric filler having a permittivity, at a frequency of 10 GHz, of 5.5 F/m or lower, the low-dielectric filler being contained in an amount of 1 to 50 parts by mass when an amount of the entire resin molded body is regarded as 100 parts by mass.

## Description

### TECHNICAL FIELD

The present invention relates to: a styrene-based resin molded body containing a syndiotactic polystyrene-based resin; and a substrate that is a laminated body composed of the styrene-based resin molded body and a metal film.

### BACKGROUND ART

In recent years, frequencies in a high-frequency band of 1 GHz or higher have been used to improve information processing speeds in the fields of information processing such as the field of personal computers (PCs) and the fields of mobile phones and the like. Therefore, a circuit board or another electronic part incorporated in a personal computer, a mobile phone, or the like is required to have a low transmission loss in the high-frequency band. The transmission loss means the extent of deterioration of an electrical signal or an optical signal propagating through a communication line. The transmission loss causes such a signal to be consumed as thermal energy and dissipated as heat, and thus, is not preferable.

In order to decrease the transmission loss, it is conceivable to use a low-dielectric polymer material having a low dielectric loss. As the low-dielectric polymer material, for example, thermoplastic resins such as polyolefins and fluorine-based resins, thermosetting resins such as unsaturated polyester resins, polyimide resins, epoxy resins, vinyltriazine resins (BT resins), crosslinkable polyphenylene oxides, and curable polyphenylene ethers, and the like have been known (see, for example, Patent Document 1).

For incorporating the above circuit board or another electronic part into a personal computer, a mobile phone, or the like so as to obtain a device, a soldering step is always performed, and thus the above low-dielectric polymer material is required to further have heat resistance. Regarding the heat resistance, the low-dielectric polymer material is required not to be deformed even when being subjected to the soldering step. Specifically, the low-dielectric polymer material is required not to be deformed even when being heated at 260°C for 120 seconds.

As a method for increasing the heat resistance, a method that includes adding an inorganic compound such as glass fiber into the polymer material has been known. However, a large amount of such an inorganic compound needs to be added to obtain a sufficient heat resistance. Consequently, a problem arises in that the permittivity of the resultant resin molded body increases, and the transmission loss thereof increases. That is, in general, since the permittivity of such an inorganic compound is high (specifically, 4 F/m or higher), increase in the amount of the added inorganic compound leads to increase also in the permittivity of the entire resin molded body and leads to increase in the transmission loss thereof.

Patent Document 2 describes a low-dielectric and heat-resistant styrene-based resin composition having a low dielectric property and a high heat resistance. The styrene-based resin composition contains 1 to 10 parts by weight of an inorganic filler and 1 to 10 parts by weight of an intercalation agent for the inorganic filler per 100 parts by weight of a syndiotactic polystyrene-based resin. Clay is used as the inorganic filler, and N-phenylmaleimide is used as the intercalation agent.

In addition, Patent Document 3 describes a low-dielectric and heat-resistant resin composition having a low dielectric property and a high heat resistance and containing 100 parts by weight of a syndiotactic polystyrene-based resin and 1 to 10 parts by weight of an interlayer-modified clay which is obtained by intercalating distearyldimethylammonium chloride into an interlayer region.

### PRIOR ART DOCUMENT

### PATENT DOCUMENT

Patent Document 1: JP-A-11-60645
Patent Document 2: JP-A-2004-323650
Patent Document 3: JP-A-2005-213317

### SUMMARY OF THE INVENTION

### PROBLEMS TO BE SOLVED BY THE INVENTION

An object of the present invention is to provide a styrene-based resin molded body containing a syndiotactic polystyrene-based resin, the resin molded body having a low transmission loss, and having heat resistance.

### SOLUTIONS TO THE PROBLEMS

The present invention is as follows.
[1] A styrene-based resin molded body contains a syndiotactic polystyrene-based resin, and a low-dielectric filler having a permittivity, at a frequency of 10 GHz, of 5.5 F/m or lower, the low-dielectric filler being contained in an amount of 1 to 50 parts by mass when an amount of the entire resin molded body is regarded as 100 parts by mass.
[2] The styrene-based resin molded body according to [1], wherein the low-dielectric filler is low-dielectric glass.
[3] The styrene-based resin molded body according to [2], wherein the low-dielectric glass contains 10 to 30% by mass of B₂O₃.
[4] The styrene-based resin molded body according to any one of [1] to [3], further comprising a high-dielectric inorganic filler having a permittivity, at the frequency of 10 GHz, of higher than 5.5 F/m, the high-dielectric inorganic filler being contained in an amount of 50 parts by mass or less when the amount of the entire resin molded body is regarded as 100 parts by mass.
[5] The styrene-based resin molded body according to any one of [1] to [4], the styrene-based resin molded body having a heating crystallization temperature of 180°C or lower.
[6] The styrene-based resin molded body according to any one of [1] to [5], the styrene-based resin molded body having a cooling crystallization temperature of 260°C or lower and a degree of crystallinity of 30% or higher.
[7] The styrene-based resin molded body according to any one of [1] to [6], the styrene-based resin molded body having a linear expansion coefficient of 200 ppm or less.
[8] The styrene-based resin molded body according to any one of [1] to [7], the styrene-based resin molded body having an L value of 70 or more and a gloss value of 30% or higher.
[9] The styrene-based resin molded body according to any one of [1] to [8], the styrene-based resin molded body being for an electronic device or a communication device used in a high-frequency band of frequencies of 1 GHz or higher.
[10] The styrene-based resin molded body according to any one of [1] to [9], the styrene-based resin molded body being a film.
[11] A substrate that is a laminated body contains the styrene-based resin molded body according to any one of [1] to [9], the styrene-based resin molded body being a film; and a metal film.

### EFFECTS OF THE INVENTION

A styrene-based resin molded body containing a syndiotactic polystyrene-based resin according to the present invention further contains: a low-dielectric filler having a permittivity, at the frequency of 10 GHz, of 5.5 F/m or lower. Since the syndiotactic polystyrene-based resin is used as a base resin, the resin molded body can be ensured to have a low permittivity (i.e., low dielectric property) and a certain extent of heat resistance. In addition, since the low-dielectric filler is contained with respect to the syndiotactic polystyrene-based resin, the heat resistance can be improved without increasing the transmission loss.

### DESCRIPTION OF EMBODIMENTS

A styrene-based resin molded body according to the present invention contains: a syndiotactic polystyrene-based resin; and a low-dielectric filler having a permittivity, at a frequency of 10 GHz, of 5.5 F/m or lower, the low-dielectric filler being contained in an amount of 1 to 50 parts by mass when an amount of the entire resin molded body is regarded as 100 parts by mass. In the styrene-based resin molded body according to the present invention, the heat resistance can be improved without increasing the transmission loss. The details thereof will be described below.

### (Syndiotactic Polystyrene-Based Resin)

The resin molded body contains a syndiotactic polystyrene-based resin. The syndiotactic polystyrene-based resin means a resin in which the proportion (hereinafter, written as syndiotacticity) of the benzene rings that are contained in adjacent styrene units and that are alternately arranged on a plane formed by the main chain of the polymer block, is high. The resin refers to a polystyrene having a syndiotacticity of ordinarily 75 mol% or higher and preferably 85 mol% or higher in terms of racemic dyad (r) or having a syndiotacticity of ordinarily 30 mol% or higher and preferably 50 mol% or higher in terms of racemic pentad (rrrr).

Whether the benzene rings are alternately arranged on a plane formed by the main chain of the polymer block can be identified through quantification according to, for example, a nuclear magnetic resonance method (¹³C-NMR) with isotopic carbon. In the ¹³C-NMR method, a plurality of consecutive constituent units are defined, e.g., two consecutive monomer units are defined as a dyad, three consecutive monomer units are defined as a triad, five consecutive monomer units are defined as a pentad, and the proportion of each of the existing monomer units can be quantified.

The syndiotactic polystyrene-based resin is preferably at least one type selected from among: polystyrene, a poly(alkylstyrene), a poly(halogenated styrene), a poly(halogenated alkylstyrene), a poly(alkoxystyrene), and a poly(vinylbenzoate); a hydrogenated polymer of any of these syndiotactic polystyrene-based resins; a mixture of two or more types selected from among these syndiotactic polystyrene-based resins; and a copolymer containing any of these syndiotactic polystyrene-based resins as a main component. Examples of the poly(alkylstyrene) include poly(methylstyrene), poly(ethylstyrene), poly(isopropylstyrene), poly(t-butylstyrene), poly(phenylstyrene), poly(vinylnaphthalene), poly(vinylstyrene), and the like. Examples of the poly(halogenated styrene) include poly(chlorostyrene), poly(bromostyrene), poly(fluorostyrene), and the like. Examples of the poly(halogenated alkylstyrene) include poly(chloromethylstyrene) and the like. Examples of the poly(alkoxystyrene) include poly(methoxystyrene), poly(ethoxystyrene), and the like. Examples of preferable styrene-based polymers among these syndiotactic polystyrene-based resins include polystyrene, poly(p-methylstyrene), poly(m-methylstyrene), poly(p- or t-butylstyrene), poly(p-chlorostyrene), poly(m-chlorostyrene), poly(p-fluorostyrene), hydrogenated polystyrene, and a copolymer containing these structural units. A styrene homopolymer (polystyrene) is particularly preferable in consideration of the fact that: the para position of the styrene is easily modified; and an ion exchange group is easily introduced. These types of syndiotactic polystyrene-based resins may be used singly, or two or more of these types of syndiotactic polystyrene-based resins may be used in combination.

The resin molded body preferably contains the syndiotactic polystyrene-based resin in an amount that falls in a range of 50 to 90 parts by mass when the amount of the entire resin molded body is regarded as 100 parts by mass. When the amount of the contained syndiotactic polystyrene-based resin is set to 50 parts by mass or more, the resin molded body can be ensured to have both a low permittivity (i.e., low dielectric property) and heat resistance. The amount of the contained syndiotactic polystyrene-based resin is more preferably 55 parts by mass or more and further preferably 60 parts by mass or more. Meanwhile, when the amount of the contained syndiotactic polystyrene-based resin is set to 90 parts by mass or less, the permittivity of the resin molded body can be inhibited from increasing, and the transmission loss thereof can be decreased. The amount of the contained syndiotactic polystyrene-based resin is more preferably 85 parts by mass or less and further preferably 80 parts by mass or less.

The syndiotactic polystyrene-based resin can be manufactured according to a publicly-known method. As the syndiotactic polystyrene-based resin, for example, "XAREC" manufactured by Idemitsu Kosan Co., Ltd. or the like can be used.

### (Low-Dielectric Filler)

The resin molded body contains a low-dielectric filler. When a predetermined amount of a low-dielectric filler is blended with the syndiotactic polystyrene-based resin, the heat resistance can be improved without increasing the transmission loss. The low-dielectric filler means a filler having a permittivity, at the frequency of 10 GHz, of 5.5 F/m or lower. The permittivity of the low-dielectric filler is preferably 5.0 F/m or lower and further preferably 4.8 F/m or lower. The permittivity of the low-dielectric filler may be measured according to the cavity resonance perturbation method.

As the low-dielectric filler, an inorganic filler and/or an organic filler can be used, and it is preferable to use at least an inorganic filler. As the inorganic filler, for example, an inorganic filler containing boron nitride or an inorganic filler containing SiO₂ is preferably used.

In a case where the low-dielectric filler is an inorganic filler containing boron nitride, the boron nitride is contained in an amount of preferably 80% by mass or higher, more preferably 90% by mass or higher, further preferably 95% by mass or higher, and most preferably 100% by mass when the amount of the entire low-dielectric filler is regarded as 100% by mass. The boron nitride has a permittivity, at the frequency of 10 GHz, of 4.5 F/m. As the boron nitride, for example, the spherical nanoscale "BN" manufactured by Denka Company Limited can be used.

In a case where the low-dielectric filler is an inorganic filler containing SiO₂, the SiO₂ is contained in an amount of preferably 45 to 99% by mass and in an amount of more preferably 48% by mass or higher and further preferably 50% by mass or higher, and meanwhile, more preferably 95% by mass or lower and further preferably 90% by mass or lower when the amount of the entire low-dielectric filler is regarded as 100% by mass.

As the low-dielectric filler, for example, low-dielectric glass can be used. The low-dielectric glass means glass having a permittivity, at the frequency of 10 GHz, of 5.5 F/m or lower.

The low-dielectric glass preferably contains 45 to 90% by mass of SiO₂ when the amount of the entire low-dielectric glass is regarded as 100% by mass. The amount of the contained SiO₂ is more preferably 48% by mass or higher and further preferably 50% by mass or higher, and meanwhile, more preferably 85% by mass or lower and further preferably 80% by mass or lower.

The low-dielectric glass preferably further contains B₂O₃, and the amount of the contained B₂O₃ is preferably 10 to 30% by mass when the amount of the entire low-dielectric glass is regarded as 100% by mass. When B₂O₃ is contained in an amount that falls in this range, the transmission loss can be decreased. The amount of the contained B₂O₃ is more preferably 12% by mass or higher and further preferably 13% by mass or higher, and meanwhile, more preferably 28% by mass or lower and further preferably 25% by mass or lower when the amount of the entire low-dielectric glass is regarded as 100% by mass.

The low-dielectric glass preferably further contains CaO, and the amount of the contained CaO is preferably 0.01 to 20% by mass when the amount of the entire low-dielectric glass is regarded as 100% by mass. When the amount of the contained CaO is set to 0.01% by mass or higher, cost can be decreased. The amount of the contained CaO is more preferably 0.05% by mass or higher and further preferably 0.1% by mass or higher. Meanwhile, when the mass of the CaO becomes excessive, the permittivity of the resin molded body tends to increase. Therefore, the amount of the contained CaO is preferably 20% by mass or lower. The amount of the contained CaO is more preferably 15% by mass or lower and further preferably 13% by mass or lower.

The low-dielectric glass may further contain SrO, and the amount of the contained SrO is preferably 0.150% by mass or lower when the amount of the entire low-dielectric glass is regarded as 100% by mass. When the amount of the contained SrO is set to 0.150% by mass or lower, the permittivity of the resin molded body can be decreased. The amount of the contained SrO is more preferably 0.120% by mass or lower and further preferably 0.080% by mass or lower. The amount of the contained SrO is preferably set to be as low as possible, but, when the amount is decreased to be lower than 0.001% by mass, productivity decreases. Therefore, the amount of the contained SrO is preferably 0.001% by mass or higher.

As the low-dielectric glass, for example, low-dielectric glass "HTD-09100T" manufactured by TOCHU CORPORATION, hollow glass bead "Q-CEL (registered trademark) 5020FPS" or "Q-CEL (registered trademark) 7040S" manufactured by Potters-Ballotini Co., Ltd., or the like can be used. The form of the low-dielectric filler is not particularly limited, and the low-dielectric filler may have a solid structure or a hollow structure, but preferably has a hollow structure. When a low-dielectric filler having a hollow structure is used, the permittivity of the resin molded body can be decreased. Surface treatment may have been performed on the low-dielectric filler by using a coupling agent. Examples of the coupling agent include silane-based coupling agents, titanate-based coupling agents, silicone oligomers, and the like.

As the organic filler, for example, a foamable resin can be used. The foamable resin refers to a resin that, by being heated, foams while generating, for example, nitrogen gas, carbon dioxide gas, carbon monoxide gas, ammonia gas, water vapor, or the like. As such a resin, for example, a resin that foams by being heated to 250°C or higher is preferably used. When a small amount of the foamable resin is contained, the permittivity of the resin molded body can be decreased. As a foaming agent for the foamable resin, for example, sodium bicarbonate, ammonium carbonate, or the like can be used. As a resin for the foamable resin, for example, an acrylic-based resin can be used. The foamable resin can be produced through, for example, a method that includes blending the foaming agent with a thermoplastic resin or a method that includes bringing nitrogen or carbon dioxide in a supercritical state into contact with the resin. As the organic filler, for example, foamable bead "ADVANCELL EM501" manufactured by SEKISUI CHEMICAL CO., LTD. can be used.

In a case where both the inorganic filler and the organic filler are used as low-dielectric fillers, the ratio of the mass of the inorganic filler used as a low-dielectric filler to the mass of the organic filler used as a low-dielectric filler (inorganic filler/organic filler) is preferably set to, for example, 10 to 20. The ratio of the mass of the inorganic filler to the mass of the organic filler is more preferably 11 or higher and further preferably 12 or higher, and meanwhile, more preferably 19 or lower and further preferably 18 or lower.

The resin molded body contains the low-dielectric filler in an amount that falls in a range of 1 to 50 parts by mass when the amount of the entire resin molded body is regarded as 100 parts by mass. When the amount of the contained low-dielectric filler is lower than 1 part by mass, the heat resistance cannot be improved. In addition, it becomes difficult to control the heating crystallization temperature of the resin molded body to be equal to or lower than a predetermined value. Therefore, the amount of the contained low-dielectric filler is set to 1 part by mass or more, preferably 3 parts by mass or more, and more preferably 5 parts by mass or more. However, when the amount of the contained low-dielectric filler exceeds 50 parts by mass, the permittivity of the resin molded body increases, and the transmission loss thereof increases. In addition, it becomes impossible to control the heating crystallization temperature of the resin molded body to be equal to or lower than the predetermined value. Therefore, the amount of the contained low-dielectric filler is set to 50 parts by mass or less, preferably 45 parts by mass or less, and more preferably 40 parts by mass or less.

In a case where the low-dielectric glass is contained in the resin molded body, the amount of the contained low-dielectric glass is preferably 90% by mass or higher, more preferably 95% by mass or higher, further preferably 98% by mass or higher, and most preferably 100% by mass when the amount of the entire low-dielectric filler is regarded as 100% by mass.

In the resin molded body, the mass ratio of the low-dielectric filler to the syndiotactic polystyrene-based resin (low-dielectric filler/syndiotactic polystyrene-based resin) preferably falls in a range of 0.05 to 0.65. The mass ratio of the low-dielectric filler to the syndiotactic polystyrene-based resin is more preferably 0.1 or higher and further preferably 0.15 or higher, and meanwhile, more preferably 0.6 or lower and further preferably 0.55 or lower.

### (High-Dielectric Inorganic Filler)

The resin molded body may contain a high-dielectric inorganic filler having a permittivity, at the frequency of 10 GHz, of higher than 5.5 F/m. When the high-dielectric inorganic filler is contained, the heat resistance can be further improved. The high-dielectric inorganic filler preferably has a permittivity, at the frequency of 10 GHz, of 10 F/m or lower. The permittivity of the high-dielectric inorganic filler may be measured according to the cavity resonance perturbation method.

The high-dielectric inorganic filler preferably contains SiO₂. In the case where the high-dielectric inorganic filler contains SiO₂, the amount of the contained SiO₂ is preferably 45 to 90% by mass when the amount of the entire high-dielectric inorganic filler is regarded as 100% by mass. The amount of the contained SiO₂ is more preferably 48% by mass or higher and further preferably 50% by mass or higher, and meanwhile, more preferably 85% by mass or lower and further preferably 80% by mass or lower.

The high-dielectric inorganic filler may further contain B₂O₃, and the amount of the contained B₂O₃ is preferably lower than 10% by mass when the amount of the entire high-dielectric inorganic filler is regarded as 100% by mass. The amount of the contained B₂O₃ is more preferably 9% by mass or lower and further preferably 8% by mass or lower when the amount of the entire high-dielectric inorganic filler is regarded as 100% by mass.

The high-dielectric inorganic filler may further contain CaO. The amount of the contained CaO is 15% by mass or higher, more preferably higher than 20% by mass, and further preferably 21% by mass or higher when the amount of the entire high-dielectric inorganic filler is regarded as 100% by mass. Regarding the upper limit of the amount of the contained CaO, the amount is, for example, preferably 40% by mass or lower, more preferably 35% by mass or lower, and further preferably 30% by mass or lower.

The high-dielectric inorganic filler may further contain SrO. The amount of the contained SrO is preferably higher than 0.150% by mass, more preferably 0.160% by mass or higher, and further preferably 0.170% by mass or higher when the amount of the entire high-dielectric inorganic filler is regarded as 100% by mass.

As the high-dielectric inorganic filler, for example, "EPH80M-01N" manufactured by Nippon Electric Glass Co., Ltd. can be used.

The amount of the high-dielectric inorganic filler contained in the resin molded body is preferably 50 parts by mass or less when the amount of the entire resin molded body is regarded as 100 parts by mass. The amount of the contained high-dielectric inorganic filler is more preferably 40 parts by mass or less and further preferably 30 parts by mass or less and may be 0 parts by mass.

In the case where the resin molded body contains the high-dielectric inorganic filler, the mass ratio of the high-dielectric inorganic filler to the above low-dielectric filler (high-dielectric inorganic filler/low-dielectric filler) is preferably 0.8 to 1.2. The mixing ratio of the high-dielectric inorganic filler to the low-dielectric filler is more preferably 0.9 or higher and further preferably 0.95 or higher, and meanwhile, more preferably 1.1 or lower and further preferably 1.05 or lower.

### (Heating Crystallization Temperature (hereinafter, sometimes written as Tc1))

The resin molded body preferably has a heating crystallization temperature (Tc1) of 180°C or lower. The heating crystallization temperature (Tc1) means the temperature at the maximal portion of an exothermic peak observed at the time of heating. By setting the heating crystallization temperature of the resin molded body to 180°C or lower, the heat resistance (solder reflow heat resistance) and a linear expansion characteristic can be further enhanced. The heating crystallization temperature of the resin molded body is more preferably 175°C or lower and further preferably 170°C or lower. The heating crystallization temperature of the resin molded body is preferably set to be as low as possible, but the lower limit thereof is ordinarily about 110°C. The heating crystallization temperature of the resin molded body can be calculated through, for example, measurement and analysis with use of a differential scanning calorimeter (hereinafter, sometimes written as DSC).

### (Cooling Crystallization Temperature (hereinafter, sometimes written as Tc2))

The resin molded body preferably has a cooling crystallization temperature (Tc2) of 260°C or lower. The cooling crystallization temperature (Tc2) means the temperature at the maximal portion of an exothermic peak observed at the time of cooling. By setting the cooling crystallization temperature of the resin molded body to 260°C or lower, productivity can be enhanced. The cooling crystallization temperature of the resin molded body is more preferably 255°C or lower and further preferably 250°C or lower. Meanwhile, regarding the lower limit of the cooling crystallization temperature of the resin molded body, the cooling crystallization temperature is preferably 180°C or higher. By setting the cooling crystallization temperature of the resin molded body to 180°C or higher, the heat resistance (solder reflow heat resistance) and the linear expansion characteristic can be enhanced. The cooling crystallization temperature of the resin molded body is more preferably 190°C or higher and further preferably 200°C or higher. The cooling crystallization temperature of the resin molded body can be calculated through, for example, measurement and analysis with use of a differential scanning calorimeter (DSC).

### (Degree of Crystallinity)

The resin molded body preferably has a degree of crystallinity of 30% or higher. The degree of crystallinity is a value obtained according to the ratio between the latent heat amount at the melting point and the latent heat amount at the cooling crystallization temperature (Tc2). By setting the degree of crystallinity of the resin molded body to 30% or higher, the heat resistance (solder reflow heat resistance) and the linear expansion characteristic can be enhanced. The degree of crystallinity of the resin molded body is more preferably 35% or higher and further preferably 40% or higher. The degree of crystallinity of the resin molded body is preferably set to be as high as possible and may be 100%. The degree of crystallinity of the resin molded body can be calculated through, for example, measurement and analysis with use of a differential scanning calorimeter (DSC).

The heating crystallization temperature, the cooling crystallization temperature, and the degree of crystallinity of the resin molded body can be controlled by, for example, adjusting the amount of the low-dielectric filler to be contained in the resin molded body or adjusting the temperature of a cooling touch roll to be used in a manufacturing process. By adjusting the temperature of the cooling touch roll to 150°C or lower, the resin molded body can be rapidly cooled, whereby the heating crystallization temperature, the cooling crystallization temperature, and the degree of crystallinity of the resin molded body can be decreased. Furthermore, the resin molded body can be prevented from being excessively softened, whereby productivity can be improved. The temperature of the cooling touch roll is preferably 120°C or lower and more preferably 100°C or lower. Meanwhile, regarding the lower limit of the temperature of the cooling touch roll, the temperature is preferably set to 10°C or higher. By setting the temperature of the cooling touch roll to 10°C or higher, a water drop can be prevented from adhering on the cooling touch roll, whereby the resin molded body can be made to have a favorable outer appearance. The temperature of the cooling touch roll is more preferably 15°C or higher and further preferably 25°C or higher.

Although the resin molded body obtained in this manner has a sufficient heat resistance as is, heat treatment may be performed on the resin molded body. By performing heat treatment, the heat resistance of the resin molded body can be further improved. In addition, by performing heat treatment, the linear expansion coefficient of the resin molded body can be decreased.

The condition for the heat treatment is as follows, for example. That is, heating is performed in a temperature range of preferably 80°C to 240°C and in a temperature range of more preferably 100°C or higher and further preferably 150°C or higher, and meanwhile, more preferably 220°C or lower and further preferably 210°C or lower. By setting the heating temperature to 80°C or higher, the heat resistance of the resin molded body can be further improved. In addition, the linear expansion coefficient of the resin molded body can be decreased. However, when the heating temperature is excessively high, the resin molded body might be deformed. Thus, the heating temperature is preferably set to 240°C or lower. A method for performing the heat treatment on the resin molded body is not particularly limited, and examples of the method include a method that includes heat setting and a method that includes radiating electron rays. The method that includes heat setting is preferable. Examples of the method that includes heat setting include a method that includes heating in a dryer so as to perform heat treatment.

The resin molded body preferably has a linear expansion coefficient of 200 ppm or less. When the linear expansion coefficient of the resin molded body is 200 ppm or less, deformation due to heat becomes less likely to occur. The linear expansion coefficient of the resin molded body is more preferably 190 ppm or less and further preferably 180 ppm or less. Meanwhile, regarding the lower limit of the linear expansion coefficient of the resin molded body, the linear expansion coefficient is, for example, preferably 80 ppm or more, more preferably 90 ppm or more, and further preferably 100 ppm or more. The linear expansion coefficient of the resin molded body can be measured by using, for example, a thermomechanical analyzer. The linear expansion coefficient of the resin molded body can be controlled by adjusting the amount of the low-dielectric filler to be contained in the resin molded body or the temperature at which heat treatment is performed.

The resin molded body preferably has a favorable outer appearance. Specifically, it is preferable that the resin molded body has an L value of 70 or more or has a gloss value of 30% or higher, and it is more preferable that the resin molded body has both an L value of 70 or more and a gloss value of 30% or higher.

### (L Value)

The resin molded body preferably has an L value (color L value) of 70 or more. The L value is a measure indicating brightness, and a larger numerical value thereof means a smaller extent of darkening and a higher brightness and leads to a more favorable outer appearance of the resin molded body and a higher product value. The L value of the resin molded body is more preferably 73 or more and further preferably 75 or more. Meanwhile, the upper limit of the L value of the resin composition is not particularly limited and may be 100, or the L value may be 90 or less. The L value may be measured as follows. That is, by using a color difference meter (the model "TC-1500MC-88" manufactured by Tokyo Denshoku Co., Ltd., or the like), light from an illuminant C is set as standard light, and the light is radiated to a center portion of a test piece, to obtain an L value of a Lab-display system.

### (Gloss Value)

The resin molded body preferably has a gloss value of 30% or higher. By setting the gloss value of the resin molded body to 30% or higher, the resin molded body comes to have a favorable outer appearance, and the product value thereof is improved. The gloss value of the resin molded body is more preferably 35% or higher and further preferably 40% or higher. The upper limit of the gloss value of the resin molded body is not particularly limited and is, for example, about 90%. The gloss value of the resin molded body can be measured and analyzed by using a glossmeter.

The L value and the gloss value of the resin molded body can be controlled by, for example, adjusting the amount of the low-dielectric filler to be contained in the resin molded body or adjusting a surface roughness Rz of the cooling touch roll to be used in the manufacturing process. The surface roughness Rz of the cooling touch roll to be used in the manufacturing process is adjusted to preferably 110 µm or less, more preferably 100 µm or less, further preferably 80 µm or less, and particularly preferably 50 µm or less.

The resin molded body can be suitably used as a material for an electronic device or a communication device used at a frequency in a high-frequency band of 1 GHz or higher. This is because the transmission loss can be kept low even when the resin molded body is used in the high-frequency band.

The resin molded body preferably has a permittivity (εr), at the frequency of 10 GHz, of 3.2 F/m or lower. The permittivity is measured according to the cavity resonance perturbation method. When the permittivity at the frequency of 10 GHz is excessively high, it becomes difficult for the resin molded body to be used for a 5G-communication device, an on-vehicle radar, or other uses.

The resin molded body preferably has a dissipation factor (Df) of 0.002 or less. When the dissipation factor of the resin molded body is 0.002 or less, it is possible to, even at the time of application of an AC electrical field, inhibit a part of energy thereof from becoming heat and being lost. The dissipation factor (Df) of the resin molded body is more preferably 0.0015 or less and further preferably 0.0013 or less. The dissipation factor may be measured at the frequency of 10 GHz according to the cavity resonance perturbation method.

The form of the resin molded body is not particularly limited, and examples of the form include forms of a film, a sheet, a board, and the like. The resin molded body is preferably in the form of a film. The film has a thickness of, for example, preferably 0.1 mm to 1 mm and a thickness of more preferably 0.15 mm or more and further preferably 0.2 mm or more, and meanwhile, more preferably 0.9 mm or less and further preferably 0.8 mm or less.

The present invention also includes a substrate that is a laminated body composed of the resin molded body according to the present invention as a film and a metal film. The substrate can be suitably used as a material for an electronic device or a communication device used at a frequency in a high-frequency band of 1 GHz or higher.

Examples of the metal film include: a film of copper, aluminum, iron, stainless steel, nickel, or the like; and a film of an alloy of these metals. Among these metal films, a copper film is most preferable.

The styrene-based resin molded body according to the present invention can be manufactured by molding the styrene-based resin composition containing: the syndiotactic polystyrene-based resin; and the low-dielectric filler having a permittivity, at the frequency of 10 GHz, of 5.5 F/m or lower. The low-dielectric filler is preferably blended in an amount that falls in a range of 1 to 50 parts by mass when the amount of the entire styrene-based resin composition is regarded as 100 parts by mass.

The substrate that is a laminated body composed of the resin molded body according to the present invention as a film and the metal film can be manufactured by stacking: a film obtained by molding the above styrene-based resin composition; and the metal film.

The present application claims priority based on Japanese Patent Application No. 2022-050817 filed on March 25, 2022. All the contents described in the Japanese Patent Application No. 2022-050817 are incorporated herein by reference.

### EXAMPLES

Hereinafter, the present invention will be more specifically described by means of examples. However, the present invention is not limited by the following examples and can also be carried out with modifications being made within the scope of the gist described above and below, and each of these modifications are included in the technical scope of the present invention.

In the Examples and Comparative Examples, the following materials were used.
· Syndiotactic polystyrene-based resin
   "XAREC130ZC" manufactured by Idemitsu Kosan Co., Ltd. was used.
· Low-dielectric filler

Low-dielectric glass "HTD-09100T" manufactured by TOCHU CORPORATION was used. "HTD-09100T" was round glass with a diameter having been subjected to silane-based surface treatment. "HTD-09100T" had a permittivity, at the frequency of 10 GHz, of 4.2 F/m. "HTD-09100T" contained SiO₂ in an amount of 51% by mass, B₂O₃ in an amount of 24% by mass, CaO in an amount of 8.7% by mass, and SrO in an amount of 0.02% by mass.

Hollow glass bead "Q-CEL (registered trademark) 5020FPS" manufactured by Potters-Ballotini Co., Ltd. was used. "Q-CEL (registered trademark) 5020FPS" had a permittivity, at the frequency of 10 GHz, of 2.6 F/m.

Hollow glass bead "Q-CEL (registered trademark) 7040S" manufactured by Potters-Ballotini Co., Ltd. was used. "Q-CEL (registered trademark) 7040S" had a permittivity, at the frequency of 10 GHz, of 1.3 F/m.

Foamable bead "ADVANCELL EM501" manufactured by SEKISUI CHEMICAL CO., LTD. was used. "ADVANCELL EM501" having foamed had a permittivity, at the frequency of 10 GHz, of 1.0 F/m.

### · High-dielectric inorganic filler

"EPH80M-01N" manufactured by Nippon Electric Glass Co., Ltd. was used. "EPH80M-01N" was round glass with a diameter and had a permittivity, at the frequency of 10 GHz, of 6.5 F/m. "HTD-09100T" contained SiO₂ in an amount of 56% by mass, B₂O₃ in an amount of 5.7% by mass, CaO in an amount of 21% by mass, and SrO in an amount of 0.18% by mass.

### (Example 1)

A resin composition 1 was obtained by mixing 78 parts by mass of "XAREC130ZC" as a syndiotactic polystyrene-based resin, and 22 parts by mass of "HTD-09100T" as a low-dielectric filler.

### (Comparative Example 1)

A resin composition 11 was obtained under the same condition as that in Example 1 except that, unlike in Example 1, 22 parts by mass of "EPH80M-01N" was used as a high-dielectric inorganic filler instead of using the low-dielectric filler.

### (Example 2)

A resin composition 2 was obtained by mixing 78 parts by mass of "XAREC130ZC" as a syndiotactic polystyrene-based resin, 11 parts by mass of "Q-CEL (registered trademark) 5020FPS" as a low-dielectric filler, and 11 parts by mass of "EPH80M-01N" as a high-dielectric inorganic filler.

### (Example 3)

A resin composition 3 was obtained by mixing 78 parts by mass of "XAREC130ZC" as a syndiotactic polystyrene-based resin, and 22 parts by mass of "Q-CEL (registered trademark) 5020FPS" as a low-dielectric filler.

### (Example 4)

A resin composition 4 was obtained by mixing 78 parts by mass of "XAREC130ZC" as a syndiotactic polystyrene-based resin, and 22 parts by mass of "Q-CEL (registered trademark) 7040S" as a low-dielectric filler.

### (Example 5)

A resin composition 5 was obtained by mixing 84 parts by mass of "XAREC130ZC" as a syndiotactic polystyrene-based resin, 15 parts by mass of "HTD-09100T" as a low-dielectric filler, and 1 part by mass of "ADVANCELL EM501" as a low-dielectric filler.

### (Example 6)

A resin composition 6 was obtained by mixing 84 parts by mass of "XAREC130ZC" as a syndiotactic polystyrene-based resin, 15 parts by mass of "Q-CEL (registered trademark) 5020FPS" as a low-dielectric filler, and 1 part by mass of "ADVANCELL EM501" as a low-dielectric filler.

### (Example 7)

A resin composition 7 was obtained by mixing 84 parts by mass of "XAREC130ZC" as a syndiotactic polystyrene-based resin, 15 parts by mass of "Q-CEL (registered trademark) 7040S" as a low-dielectric filler, and 1 part by mass of "ADVANCELL EM501" as a low-dielectric filler.

The resin compositions (resin compositions 1 to 7 and 11) obtained in the above Examples and Comparative Examples were supplied into a same-direction twin-screw extruder having a screw diameter of 50 mm and were extruded. Then, the extruded resin compositions were cooled with water, granulated, and made into resin pellets. The obtained resin pellets were supplied into a same-direction single-screw extruder having a screw diameter of 50 mm and were cooled by using a cooling touch roll, whereby rod-shaped test materials (0.3 mmΦ × 300 mm) and sheet-shaped test materials (130 mm in length × 100 mm in width × 0.3 mm in thickness) were manufactured as resin molded bodies. The cooling touch roll having been used had a surface roughness Rz of 30 µm, and the temperature of the cooling touch roll was set to 25°C. The component compositions of the test materials are indicated in Table 1 presented below. In Table 1 presented below, the mass ratio of the low-dielectric filler to the syndiotactic polystyrene-based resin contained in each of the test materials (low-dielectric filler/syndiotactic polystyrene-based resin) and the mass ratio of the high-dielectric inorganic filler to the low-dielectric filler contained in each of the test materials (high-dielectric inorganic filler/low-dielectric filler) are indicated together.

### (Example 8)

The resin composition 1 obtained in Example 1 was used to manufacture a rod-shaped test material (0.3 mmΦ × 300 mm) and a sheet-shaped test material (130 mm in length × 100 mm in width × 0.3 mm in thickness) under the same condition as the above condition except that a cooling touch roll having a surface roughness Rz of 110 µm was used. The component composition of the test material is indicated in the column of Example 8. The component composition in Example 8 is the same as the component composition in Example 1.

### (Example 9)

The rod-shaped test material (0.3 mmΦ × 300 mm) and the sheet-shaped test material (130 mm in length × 100 mm in width × 0.3 mm in thickness) manufactured in Example 1 were subjected to heat setting by using a dryer at 200°C for 1 hour. The component composition of the test materials is indicated in the column of Example 9. The component composition in Example 9 is the same as the component composition in Example 1.

### (Example 10)

The rod-shaped test material (0.3 mmΦ × 300 mm) and the sheet-shaped test material (130 mm in length × 100 mm in width × 0.3 mm in thickness) manufactured in Example 1 were subjected to heat setting by using a dryer at 170°C for 1 hour. The component composition of the test materials is indicated in the column of Example 10. The component composition in Example 10 is the same as the component composition in Example 1.

### (Example 11)

The rod-shaped test material (0.3 mmΦ × 300 mm) and the sheet-shaped test material (130 mm in length × 100 mm in width × 0.3 mm in thickness) manufactured in Example 1 were subjected to heat setting by using a dryer at 150°C for 1 hour. The component composition of the test materials is indicated in the column of Example 11. The component composition in Example 11 is the same as the component composition in Example 1.

### (Example 12)

The resin composition 4 obtained in Example 4 was used to manufacture a rod-shaped test material (0.3 mmΦ × 300 mm) and a sheet-shaped test material (130 mm in length × 100 mm in width × 0.3 mm in thickness) under the same condition as the above condition except that a cooling touch roll having a surface roughness Rz of 110 µm was used. The component composition of the test material is indicated in the column of Example 12. The component composition in Example 12 is the same as the component composition in Example 4.

### (Example 13)

The rod-shaped test material (0.3 mmΦ × 300 mm) and the sheet-shaped test material (130 mm in length × 100 mm in width × 0.3 mm in thickness) manufactured in Example 4 were subjected to heat setting by using a dryer at 150°C for 1 hour. The component composition of the test materials is indicated in the column of Example 13. The component composition in Example 13 is the same as the component composition in Example 4.

Regarding each of the obtained sheet-shaped test materials, the heating crystallization temperature, the cooling crystallization temperature, and the degree of crystallinity of the sheet-shaped test material were calculated through measurement and analysis with use of a DSC. Meanwhile, regarding each of the obtained rod-shaped test materials, the permittivity of the rod-shaped test material at the frequency of 10 GHz was measured to evaluate the dielectric characteristic thereof. In addition, regarding each of the obtained rod-shaped test materials, the dissipation factor of the rod-shaped test material at the frequency of 10 GHz was measured. Furthermore, an evaluation was performed regarding the film formability exhibited when the resin pellets made from the resin composition obtained in each of the Examples and the Comparative Examples were processed into a sheet-shaped test material. Regarding each of the obtained sheet-shaped test materials, the heat resistance of the sheet-shaped test material was evaluated, and the linear expansion coefficient of the sheet-shaped test material was measured to evaluate the linear expansion characteristic thereof. In addition, the L value and the gloss value of each of the obtained sheet-shaped test materials were measured.

### (Heating Crystallization Temperature (Tc1), Cooling Crystallization Temperature (Tc2), and Degree of Crystallinity)

Regarding each of the rod-shaped test materials, the heating crystallization temperature, the cooling crystallization temperature, and the degree of crystallinity of the rod-shaped test material were measured by using the differential scanning calorimeter (DSC) "TAS100-type heat analysis system" manufactured by TA Instruments Corporation. The amount of 5.0±0.3 mg of a test piece cut out from the rod-shaped test material was put into a pan made of aluminum and was heated from room temperature to 320°C at a temperature increase rate of 20°C/min, and the heating crystallization temperature (Tc1) of the test piece was measured. Furthermore, after reaching 320°C, the temperature was maintained for 5 minutes. Then, the test piece was cooled at a temperature decrease rate of 20°C/min, and the cooling crystallization temperature (Tc2) of the test piece was measured. The heating crystallization temperature (Tc1) and the cooling crystallization temperature (Tc2) were the temperatures of the maximal portions of the respective peaks. The degree of crystallinity was obtained from the ratio between the latent heat amount at the melting point and the latent heat amount at the cooling crystallization temperature (Tc2). The calculation results are indicated in Table 1 presented below.

### (Dielectric Characteristic)

A test piece (0.3 mmΦ × 100 mm) was cut out from each of the rod-shaped test materials (0.3 mmΦ × 300 mm), and the permittivity (εr) and the dissipation factor (Df) of the test piece at the frequency of 10 GHz were measured according to the cavity resonance perturbation method. For the measurement of the permittivity and the dissipation factor, "Precision LCR Meter" manufactured by Agilent Technologies, Inc. was used. The measurement results are indicated in Table 1 presented below. In addition, a dielectric characteristic was evaluated on the basis of the measured permittivity (εr) according to the following criteria. The evaluation results are indicated in Table 1 presented below.

### (Evaluation Criteria)

Acceptable dielectric characteristic (A): The permittivity (εr) was 3.2 F/m or lower.

Unacceptable dielectric characteristic (B): The permittivity (εr) was higher than 3.2 F/m.

Dissipation factors of 0.002 or less were evaluated as being acceptable, and dissipation factors exceeding 0.002 were evaluated as being unacceptable.

### (Film Formability)

At the time of supplying the obtained resin pellets into the single-screw extruder so as to manufacture a sheet-shaped test material (130 mm in length × 100 mm in width × 0.3 mm in thickness), in the case of succeeding in manufacturing the sheet-shaped test material, the film formability was evaluated as being acceptable (A), whereas, in the case of failing to manufacture the sheet-shaped test material, the film formability was evaluated as being unacceptable (B). In the case where the film formability was unacceptable, the subsequent measurement and evaluation of the physical properties were not performed.

### (Heat Resistance)

A test piece (35 mm in length × 5 mm in width × 0.3 mm in thickness) was cut out from each of the sheet-shaped test materials (130 mm in length × 100 mm in width × 0.3 mm in thickness), and the obtained test piece was dipped for 120 seconds in a solder bath heated to 260°C. The forms of the test piece before and after the dipping were visually observed, whereby presence/absence of deformation was checked. In a case where no deformation was found between before and after the dipping, the heat resistance was evaluated as being acceptable (A). In a case where the test piece was slightly deformed but was able to be sufficiently used, the heat resistance was evaluated as being acceptable (between A and B). In a case where the test piece was deformed a little but was able to be used, the heat resistance was evaluated as being acceptable (B). In a case where an obvious deformation was found and the test piece was unable to be used, the heat resistance was evaluated as being unacceptable (C). The evaluation results are indicated in Table 1 presented below.

### (Linear Expansion Characteristic)

A test piece (50 mm in length × 50 mm in width × 0.3 mm in thickness) was cut out from each of the sheet-shaped test materials (130 mm in length × 100 mm in width × 0.3 mm in thickness), and the linear expansion coefficient of the obtained test piece was measured by using a thermomechanical analyzer (the film adapter "TM7000" manufactured by Hitachi High-Tech Corporation). The measurement temperature range was set to 30°C to 200°C. The measurement results are indicated in Table 1 presented below. In a case where the linear expansion coefficient was 200 ppm or less, the linear expansion characteristic was evaluated as being acceptable. Meanwhile, in a case where the linear expansion coefficient exceeded 200 ppm, the linear expansion characteristic was evaluated as being unacceptable. The evaluation results are indicated in Table 1 presented below.

### (L Value)

A test piece (50 mm in length × 50 mm in width × 0.3 mm in thickness) was cut out from each of the sheet-shaped test materials (130 mm in length × 100 mm in width × 0.3 mm in thickness) and was used as an evaluation sample. The model "TC-1500MC-88" manufactured by Tokyo Denshoku Co., Ltd. was used as a color difference meter, an illuminant C was used, and light was radiated to a center portion of the evaluation sample, to measure the L value of the Lab-display system. The measurement results are indicated in Table 1 presented below.

### (Gloss Value)

A test piece (70 mm in length × 70 mm in width × 0.3 mm in thickness) was cut out from each of the sheet-shaped test materials (130 mm in length × 100 mm in width × 0.3 mm in thickness) and was used as an evaluation sample. "VG-2000" manufactured by NIPPON DENSHOKU INDUSTRIES Co., Ltd. was used as a glossmeter, and a gloss value at a surface angle of 60° was used at the measurement. The measurement results are indicated in Table 1 presented below.

**[Table 1-1]**

| | | | Example 1 | Comparative Example 1 | Example 2 | Example 3 | Example 4 | Example 5 | Example 6 |
|---|---|---|---|---|---|---|---|---|---|
| Resin composition | | | 1 | 11 | 2 | 3 | 4 | 5 | 6 |
| Syndiotactic Polystyrene-Based Resin | XAREC130ZC | part by mass | 78 | 78 | 78 | 78 | 78 | 84 | 84 |
| Low-Dielectric Filler | HTD-09100T | part by mass | 22 | - | - | - | - | 15 | - |
| | Q-CEL5020FPS | part by mass | - | - | 11 | 22 | - | - | 15 |
| | Q-CEL7040S | part by mass | - | - | - | - | 22 | - | - |
| | ADVANCELL EM501 | part by mass | - | - | - | - | - | 1 | 1 |
| High-Dielectric Inorganic Filler | EPH80M-01N | part by mass | - | 22 | 11 | - | - | - | - |
| Total amount | | part by mass | 100 | 100 | 100 | 100 | 100 | 100 | 100 |
| Low-Dielectric Filler/Syndiotactic Polystyrene-Based Resin | | mass ratio | 0.28 | - | 0.28 | 0.28 | 0.28 | 0.18 | 0.18 |
| High-Dielectric Inorganic Filler/Low-Dielectric Filler | | mass ratio | - | - | 1 | - | - | - | - |
| Heating Crystallization Temperature(Tc1) | | °C | 140 | 190 | 148 | 147 | 148 | 147 | 146 |
| Cooling Crystallization Temperature(Tc2) | | °C | 240 | 250 | 245 | 245 | 245 | 245 | 245 |
| Degree of Crystallinity | | % | 41 | 25 | 45 | 45 | 45 | 45 | 45 |
| Dielectric Characteristic | Permittivity( *ε* r) | F/m | 2.9 | 3.4 | 3.1 | 2.4 | 2.1 | 2.6 | 2.3 |
| | Evaluation results | | A | B | A | A | A | A | A |
| | Dissipation factor(Df) | | 0.0009 | 0.001 | 0.0009 | 0.0009 | 0.0009 | 0.0009 | 0.0009 |
| Film Formability | | | A | A | A | A | A | A | A |
| Heat Resistance | | | B | B | B | B | B | B | B |
| Linear Expansion Characteristic | Linear Expansion Coefficient | ppm | 200 | 148 | 140 | 130 | 130 | 150 | 150 |
| Outer appearance | L Value | | 82 | 68 | 81 | 81 | 81 | 82 | 81 |
| | Gloss Value | % | 35 | 25 | 31 | 31 | 32 | 35 | 35 |

**[Table 1-2]**

| | | | Example 7 | Example 8 | Example 9 | Example 10 | Example **11** | Example **12** | Example 13 |
|---|---|---|---|---|---|---|---|---|---|
| Resin composition | | | 7 | 1 | 1 | 1 | 1 | 4 | 4 |
| Syndiotactic Polystyrene-Based Resin | XAREC130ZC | part by mass | 84 | 78 | 78 | 78 | 78 | 78 | 78 |
| Low-Dielectric Filler | HTD-09100T | part by mass | - | 22 | 22 | 22 | 22 | - | - |
| | Q-CEL5020FPS | part by mass | - | - | - | - | - | - | - |
| | Q-CEL7040S | part by mass | 15 | - | - | - | - | 22 | 22 |
| | ADVANCELL EM501 | part by mass | 1 | - | - | - | - | - | - |
| High-Dielectric Inorganic Filler | EPH80M-01N | part by mass | - | - | - | - | - | - | - |
| Total amount | | part by mass | 100 | 100 | 100 | 100 | 100 | 100 | 100 |
| Low-Dielectric Filler/Syndiotactic Polystyrene-Based Resin | | mass ratio | 0.18 | 0.28 | 0.28 | 0.28 | 0.28 | 0.28 | 0.28 |
| High-Dielectric Inorganic Filler/Low-Dielectric Filler | | mass ratio | - | - | - | - | - | - | - |
| Heating Crystallization Temperature(Tel) | | °C | 146 | 145 | 145 | 150 | 155 | 145 | 156 |
| Cooling Crystallization Temperature(Tc2) | | °C | 245 | 250 | 250 | 240 | 235 | 250 | 234 |
| Degree of Crystallinity | | % | 45 | 35 | 95 | 90 | 88 | 35 | 87 |
| Dielectric Characteristic | Permittivity( *ε* r) | F/m | 2.1 | 3 | 2.8 | 2.9 | 2.9 | 2.3 | 1.9 |
| | Evaluation results | | A | A | A | A | A | A | A |
| | Dissipation factor(Df) | | 0.0009 | 0.0011 | 0.0008 | 0.0009 | 0.0009 | 0.0009 | 0.0009 |
| Film Formability | | | A | A | A | A | A | A | A |
| Heat Resistance | | | B | B | A | Between A and B | Between A and B | B | B |
| Linear Expansion Characteristic | Linear Expansion Coefficient | ppm | 150 | 140 | 130 | 133 | 135 | 150 | 125 |
| Outer appearance | L Value | | 82 | 81 | 81 | 81 | 81 | 81 | 81 |
| | Gloss Value | % | 37 | 27 | 60 | 55 | 55 | 28 | 55 |

The following observations can be made on the basis of Table 1. In each of Examples 1 to 13, the resin molded body satisfies the requirements defined in the present invention, has a low permittivity, and exhibits both a low dielectric property and heat resistance. In particular, in comparison between Example 1 and Example 8, or between Example 4 and Example 12, it is found that decrease in the surface roughness Rz of the cooling touch roll leads to improvement of the L value and the gloss value of the sheet-shaped test material and leads to a favorable outer appearance. In comparison between Example 1 and each of Examples 9 to 11, or between Example 4 and Example 13, it is found that the heat resistance is further improved by performing heat setting on the resin molded body. In comparison among Examples 9 to 11, it is found that, as the temperature of heat setting to be performed on the resin molded body is set to be higher, the heat resistance is more improved and the linear expansion coefficient becomes smaller. Meanwhile, Comparative Example 1 is an example in which a high-dielectric inorganic filler having a permittivity, at the frequency of 10 GHz, of higher than 5.5 F/m (specifically, a permittivity of 6.5 F/m) was used without using any low-dielectric filler having a permittivity, at the frequency of 10 GHz, of 5.5 F/m or lower. The resin molded body in Comparative Example 1 had a high permittivity, and the transmission loss thereof was increased.

## Claims

1. A styrene-based resin molded body comprising:
a syndiotactic polystyrene-based resin; and
a low-dielectric filler having a permittivity, at a frequency of 10 GHz, of 5.5 F/m or lower, the low-dielectric filler being contained in an amount of 1 to 50 parts by mass when an amount of the entire resin molded body is regarded as 100 parts by mass.

2. The styrene-based resin molded body according to claim 1, wherein the low-dielectric filler is low-dielectric glass.

3. The styrene-based resin molded body according to claim 2, wherein the low-dielectric glass contains 10 to 30% by mass of B₂O₃.

4. The styrene-based resin molded body according to claim 1, further comprising a high-dielectric inorganic filler having a permittivity, at the frequency of 10 GHz, of higher than 5.5 F/m, the high-dielectric inorganic filler being contained in an amount of 50 parts by mass or less when the amount of the entire resin molded body is regarded as 100 parts by mass.

5. The styrene-based resin molded body according to claim 1, the styrene-based resin molded body having a heating crystallization temperature of 180°C or lower.

6. The styrene-based resin molded body according to claim 1, the styrene-based resin molded body having a cooling crystallization temperature of 260°C or lower and a degree of crystallinity of 30% or higher.

7. The styrene-based resin molded body according to claim 1, the styrene-based resin molded body having a linear expansion coefficient of 200 ppm or less.

8. The styrene-based resin molded body according to claim 1, the styrene-based resin molded body having an L value of 70 or more and a gloss value of 30% or higher.

9. The styrene-based resin molded body according to claim 1, the styrene-based resin molded body being for an electronic device or a communication device used in a high-frequency band of frequencies of 1 GHz or higher.

10. The styrene-based resin molded body according to claim 1, the styrene-based resin molded body being a film.

11. A substrate that is a laminated body comprising:
the styrene-based resin molded body according to claim 1, the styrene-based resin molded body being a film; and
a metal film.
